# FASCICULE DE BREVET EUROPEEN

(11) **EP 4 074 152 B1**
(45) Date de publication et mention de la délivrance du brevet: **22.10.2025**
(21) Numéro de dépôt: 20828545.2
(22) Date de dépôt: 02.12.2020
(51) Int. Cl.: H05K 7/20

(54) **ENSEMBLE D'UNE CARTE ÉLECTRONIQUE ET D'UN DISSIPATEUR THERMIQUE, ET GROUPE MOTO-VENTILATEUR COMPRENANT UN TEL ENSEMBLE**
ANORDNUNG EINER ELEKTRONIKKARTE UND EINER WÄRMESENKE UND MOTORLÜFTEREINHEIT MIT EINER SOLCHEN ANORDNUNG
ASSEMBLY OF AN ELECTRONIC BOARD AND A HEAT SINK, AND MOTOR-FAN UNIT COMPRISING SUCH AN ASSEMBLY

(30) Priorité: 12.12.2019 FR 1914322
(43) Date de publication de la demande: 19.10.2022
(73) Titulaire: VALEO SYSTEMES THERMIQUES, 78320 Le Mesnil Saint-Denis (FR)
(72) Inventeur: FRANCO, Ismaël, 78320 LE MESNIL SAINT-DENIS (FR); PROVINZANO, Biagio, 78320 LE MESNIL SAINT-DENIS (FR); TAS, Onur, 78320 LE MESNIL SAINT-DENIS (FR)
(74) Mandataire: Valeo Powertrain Systems
(86) Numéro de dépôt international: PCT/FR2020/052245
(87) Numéro de publication internationale: WO 2021/116561

(56) Documents cités:
- FR-A1- 2 921 446
- GB-A- 2 162 694
- US-A- 5 285 350
- US-B1- 6 600 655

## Description

### Domaine technique

L'invention concerne un ensemble d'une carte électronique et d'un dissipateur thermique pour un groupe moto-ventilateur de véhicule automobile. L'invention concerne également un tel groupe moto-ventilateur et un dispositif de ventilation pour véhicule automobile comprenant un tel groupe moto-ventilateur.

### Technique antérieure

Un groupe moto-ventilateur équipe un dispositif de ventilation, de chauffage et/ou de climatisation de véhicule automobile, qui assure la régulation de la température d'un flux d'air destiné à alimenter l'habitacle du véhicule.

Le groupe moto-ventilateur permet de faire entrer et circuler le flux d'air dans le dispositif de ventilation, de chauffage et/ou de climatisation jusqu'à des bouches de sortie, où l'air pénètre dans l'habitacle.

Le groupe moto-ventilateur comporte de façon connue un moteur électrique, par exemple à balais, sur lequel est montée une roue pour mettre l'air en mouvement, un dispositif de commande du moteur électrique, le dispositif de commande du moteur électrique comprenant une carte électronique et des composants électroniques, ainsi qu'un dissipateur thermique.

Dans le groupe moto-ventilateur, le dissipateur thermique a pour fonction de refroidir la carte électronique et les composants électroniques de commande du moteur, en particulier des composantes hautes puissances. De manière classique, le dissipateur thermique se présente sous la forme d'une plaque munie de plots faisant saillie hors de la plaque, la plaque et les plots étant réalisés dans un matériau conducteur thermique.

Cette solution présente l'inconvénient d'être encombrante, en raison de la présence des plots. De plus, l'efficacité du refroidissement n'est pas toujours satisfaisante. Le poids de ce type de dissipateur thermique est également relativement élevé.

De plus, un dissipateur thermique comprenant des plots est classiquement réalisé par moulage. Ce procédé de fabrication est particulièrement couteux, ce qui augmente le coût total du dissipateur thermique.

Un but de l'invention est de fournir un ensemble d'une carte électronique et d'un dissipateur thermique ne présentant pas au moins certains des inconvénients de l'art antérieur.

Par ailleurs, il est connu de la demande non publiée FR1901364 un dissipateur thermique pour une carte électronique d'un groupe moto-ventilateur de véhicule automobile, comprenant une surface destinée à échanger thermiquement avec un flux d'air mis en mouvement par le groupe moto-ventilateur, dite surface d'échanges, ladite surface d'échanges comprenant une portion plane agencée pour que, dans une position installée dans le groupe moto-ventilateur, le flux d'air mis en mouvement par le groupe moto-ventilateur s'écoule sensiblement parallèlement à ladite portion plane, la surface d'échanges comprenant également un ensemble de cavités non traversantes affleurant ladite portion plane. Un autre ensemble d'une carte électronique et d'un dissipateur thermique pour un groupe moto-ventilateur de véhicule automobile est connu du document FR2921446.

### Résumé

La présente description propose un ensemble d'une carte électronique et d'un dissipateur thermique, notamment pour un groupe moto-ventilateur de véhicule automobile, selon la revendication 1.

Il est ainsi possible de fabriquer le dissipateur thermique par extrusion et découpe. Alternativement, le dissipateur thermique peut être fabriqué par poinçonnage d'une plaque métallique. Chacun de ces procédés de fabrication est plus économique qu'un procédé de moulage, ce qui permet de réduire le coût du dissipateur thermique.

De plus, cette configuration améliore de façon inattendue la convection de l'air contre la surface de la plaque du dissipateur thermique, ce qui permet de rendre plus efficace le refroidissement par le dissipateur thermique. Cette configuration assure la réduction de l'encombrement du dissipateur thermique, ce qui permet aussi d'améliorer les performances aérauliques et acoustiques en réduisant les pertes de charge. En effet, le dissipateur offre moins de résistance dans le flux d'air.

En outre, le dissipateur ainsi réalisé est plus léger que ceux connus de l'art antérieur.

L'ensemble de la carte électronique et du dissipateur thermique peut présenter une ou plusieurs des caractéristiques suivantes :
- la pâte thermique, disposée entre la carte électronique et la plaque, est étanche et/ou collante ;
- la pâte thermique, disposée entre la carte électronique et la plaque, possède une conductivité thermique comprise entre 1 W/mK et 50 W/mK ;
- la pâte thermique est une résine époxyde ou en silicone;
- la pâte thermique forme une couche, d'épaisseur comprise entre 25 µm et 450 µm, entre la carte électronique et la plaque ;
- la couche de pâte thermique présente au moins un relief s'étendant dans une ouverture traversante de la plaque ;
- chaque ouverture traversante de la plaque a une section polygonale, notamment hexagonale ou rectangulaire, ou circulaire ;
- les ouvertures traversantes de la plaque sont de section polygonale, un rapport entre l'épaisseur de la plaque et la longueur d'un côté de la section polygonale étant compris entre 0,005 et 0,5 ;
- chaque ouverture traversante a une section comprise entre 10 mm² et 500 mm² ;
- les ouvertures traversantes sont disposées selon un maillage de quadrilatères, par exemple rectangulaires et/ou en quinconce, ou selon un maillage en nid d'abeille ; le composant électronique a de préférence
   au moins deux pattes de fixation, chaque patte de fixation étant reçue dans une ouverture traversante ;
- un composant électronique a au moins deux pattes de fixation, chaque patte de fixation étant reçue dans une ouverture traversante ;
- un composant électronique a au moins deux pattes de fixation, chaque patte de fixation étant reçue dans une ouverture traversante respective, les ouvertures traversantes respectives étant de préférence adjacentes ;
- la plaque et/ou la carte électronique est/sont dépourvue/s de trous de fixations par une vis ou bouterolle ;
- la plaque comprend au moins un trou de fixation par une vis ou bouterolle, la plaque étant de préférence dépourvue d'ouverture traversante au voisinage du trou de fixation ; et
- la plaque est en un alliage d'aluminium, par exemple AlSi12, Al9Cu ou AlSi10.

Selon un autre aspect, il est également décrit un groupe moto-ventilateur pour un véhicule automobile, comprenant un moteur, une roue de mise en mouvement d'un flux d'air configurée pour être entrainée par le moteur, un dispositif de commande du moteur, le dispositif de commande comportant un ensemble d'une carte électronique et d'un dissipateur thermique tel que décrit ci-avant dans toutes ses combinaisons.

Selon un autre aspect, il est également décrit un dispositif de ventilation pour un véhicule automobile, comprenant :
- un groupe moto-ventilateur tel que décrit ci-avant dans toutes ses combinaisons,
- un conduit, la roue du groupe moto-ventilateur étant reçue dans le conduit, la plaque étant reçue dans le conduit, la plaque formant en particulier au moins une portion d'une paroi du conduit.

Selon encore un autre aspect, il est aussi décrit un procédé de fabrication d'un ensemble d'une carte électronique et d'un dissipateur thermique tel que décrit ci-avant dans toutes ses combinaisons, comprenant les étapes de :
- fourniture de la plaque, dans lequel l'étape de fourniture de la plaque comporte de préférence une sous-étape d'extrusion d'un profilé dont la section correspond à la section de la plaque, puis une sous-étape de découpe d'une plaque dans le profilé ;
- application de la pâte thermique sur la carte électronique et/ou sur la plaque; et
- fixation de la plaque sur la carte électronique.

L'étape de fourniture de la plaque peut également comporter une sous-étape de fourniture d'une plaque pleine, puis une sous-étape de poinçonnage de la plaque pleine.

L'étape de fixation de la plaque sur la carte électronique peut également comprendre une sous-étape de polymérisation à l'air de la pâte thermique.

L'étape de fixation de la plaque sur la carte électronique peut également comprendre une sous-étape de polymérisation par chauffage de la pâte thermique

### Brève description des dessins

D'autres caractéristiques, détails et avantages apparaîtront à la lecture de la description détaillée ci-après, et à l'analyse des dessins annexés, sur lesquels :
[Fig. 1] illustre une vue en coupe partielle d'un détail d'un dispositif de ventilation de véhicule comprenant un groupe moto-ventilateur.
[Fig. 2] illustre une vue en perspective d'un premier exemple d'ensemble d'une carte électronique et d'un dissipateur thermique pouvant être mis en œuvre dans le groupe moto-ventilateur de la Figure 1.
[Fig. 3] illustre une vue de dessus du premier exemple d'ensemble d'une carte électronique et d'un dissipateur thermique de la Figure 2.
[Fig. 4] illustre un détail d'une coupe longitudinale du premier exemple d'ensemble d'une carte électronique et d'un dissipateur thermique de la Figure 2.
[Fig. 5] illustre un autre détail d'une coupe longitudinale de l'ensemble de la carte électronique et du dissipateur thermique de la Figure 2.
[Fig. 6] illustre une vue de face d'un deuxième exemple d'ensemble d'une carte électronique et d'un dissipateur thermique, qui peut être mis en œuvre dans le groupe moto-ventilateur de la Figure 1.
[Fig. 7] illustre une vue de face d'un troisième exemple d'ensemble d'une carte électronique et d'un dissipateur thermique, qui peut être mis en œuvre dans le groupe moto-ventilateur de la Figure 1.
[Fig. 8] illustre un ordinogramme d'un procédé de fabrication permettant d'obtenir un ensemble d'une carte électronique et d'un dissipateur thermique selon l'une des Figures 2, 6 ou 7.

### Description des modes de réalisation

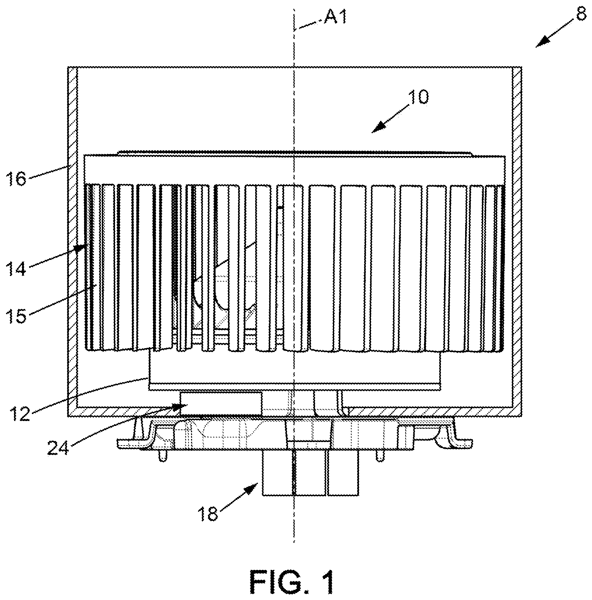

Un dispositif de ventilation pour un véhicule automobile dont un détail est illustré dans la Figure 1 est décrit ci-dessous en référence aux dessins.

Le dispositif de ventilation 8 intègre un groupe moto-ventilateur 10. Le groupe moto-ventilateur 10 comporte un ventilateur 14. Le ventilateur 14 comprend ici un moteur électrique 12 et une roue 15 configurée pour être entrainée par le moteur 12 en rotation autour d'un axe de rotation A1 commun au moteur 14 et à la roue 15. La roue 15 est ici reçue dans un conduit 16 du dispositif de ventilation 8. Ainsi, le ventilateur 14 génère un flux d'air dans le conduit 16.

Le groupe moto-ventilateur 10 comprend également un dispositif 18 de commande du moteur électrique 12. Le dispositif de commande 18 inclut une carte électronique 22 et des composants électroniques 20 fixés sur la carte électronique 22 (non visibles sur la figure 1). Le dispositif de commande 18 permet de contrôler le moteur électrique 12 du ventilateur 14.

Le groupe moto-ventilateur 10 comprend également un dissipateur thermique 24 apte à refroidir le dispositif de commande 18. Comme illustré sur la Figure 1, le dissipateur thermique 24 est reçu dans le conduit 16 dans lequel est reçue la roue 15 du ventilateur 14. Alternativement, le dissipateur thermique 24 peut être agencé de manière à former une portion d'une paroi du conduit 16. Ces configurations permettent au dissipateur thermique 24 d'échanger thermiquement avec le flux d'air généré par le ventilateur 14, notamment par convection.

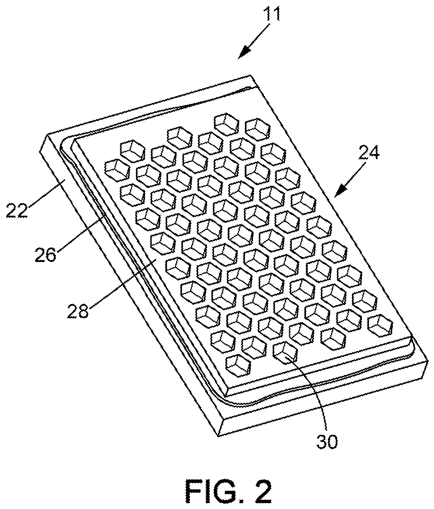

Comme illustré à la figure 2, le dissipateur thermique 24 comprend une plaque 28 et une pâte thermique 26. Le dissipateur thermique 24 est fixé à la carte électronique 22. La pâte thermique 26 est disposée entre la plaque 28 et la carte électronique 22. Ainsi, le groupe moto-ventilateur 10 comprend un ensemble 11 composé de la carte électronique 22 et du dissipateur thermique 24.

La plaque 28 du dissipateur thermique 24 a une surface, dans un plan parallèle au plan d'extension de la carte électronique 22, présentant des ouvertures traversantes 30. Les ouvertures traversantes 30 permettent au flux d'air généré par le ventilateur 14 de pénétrer à l'intérieur de ces ouvertures traversantes 30 tout en créant des turbulences du flux d'air au voisinage de la plaque 28. De plus, les ouvertures traversantes 30 permettent de limiter le poids de la plaque 28 et, ce faisant, le poids du dissipateur thermique 24.

La plaque 28 est de préférence en un matériau présentant une bonne conductivité thermique. Par exemple, la plaque 28 peut-être en alliage d'aluminium, notamment AlSi₁₂, Al₉Cu ou AlSi₁₀. Ces alliages ont l'avantage d'avoir une bonne conductivité thermique tout en étant relativement légers.

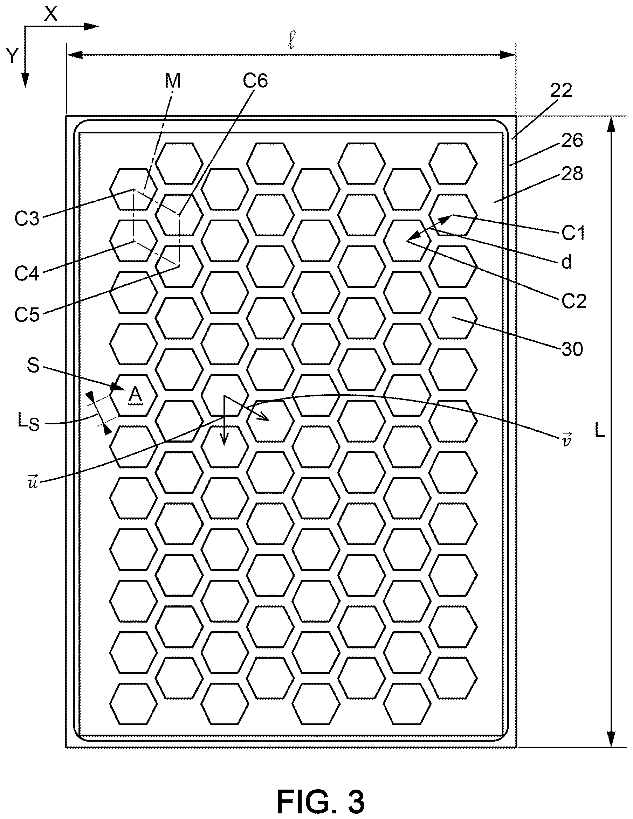

Comme illustré sur les Figures 2 et 3, les ouvertures traversantes 30 dans la plaque 28 peuvent être de section S polygonale. Une telle section S polygonale est relativement facile à réaliser. Dans l'exemple illustré, la section S est hexagonale. De préférence, la section S a la forme d'un polygone régulier, notamment d'un hexagone régulier.

Les ouvertures traversantes 30 sont de section sensiblement constante à travers la plaque 28. En d'autres termes, les ouvertures traversantes 30 sont sensiblement cylindriques, ici de section polygonale. Alternativement cependant, les ouvertures traversantes 30 peuvent être tronconiques. En d'autres termes, la section transversale des ouvertures traversantes 30 peut être réduite sur une face de la plaque 28 par rapport à l'autre face de la plaque 28. Ceci peut notamment être le cas lorsque les ouvertures traversantes 30 sont réalisées par poinçonnage.

L'aire A de la section S des ouvertures traversantes 30 est par exemple comprise entre 10 mm² et 500 mm². L'aire A s'entend de l'aire maximale de la section S, le cas échéant.

La plaque 28 a une longueur L, une largeur l et une épaisseur e. La longueur L de la plaque 28 correspond à sa plus grande dimension. Par exemple, la longueur de la plaque 28 est comprise entre 50 mm et 200 mm. La largeur l correspond à la deuxième dimension la plus grande de la plaque 28, qui peut éventuellement être égale à la plus grande dimension de la plaque 28. La largeur l de la plaque 28 est par exemple comprise entre 25 mm et 180 mm. Ici, la longueur L et la largeur l de la plaque 28 sont mesurées dans un plan parallèle au plan d'extension de la carte électronique 22. Enfin, l'épaisseur e1 de la plaque 28 est la plus petite dimension de la plaque 28. Ici, l'épaisseur e1 est mesurée selon une direction normale au plan d'extension de la carte électronique 22. L'épaisseur e1 de la plaque 28 est par exemple comprise entre 0.5 mm et 5 mm. L'épaisseur e1 de la plaque 28 est avantageusement de dimension réduite par rapport à la longueur L et à la largeur l de la plaque 28. Par exemple, l'épaisseur e1 de la plaque 28 est au moins dix fois plus petite que la longueur L et la largeur l de la plaque 28, de préférence au moins cinquante fois plus petite que la longueur L et la largeur l de la plaque 28. Les ouvertures traversantes 30 sont orientées selon la direction de l'épaisseur de la plaque 28.

Un rapport e1/L entre l'épaisseur e1 de la plaque 28 et la longueur L d'un côté de la section polygonale S est par exemple compris entre 0,005 et 0,5. Un tel rapport assure une bonne circulation du flux d'air généré par le ventilateur 14 dans les ouvertures traversantes 30.

Un rapport entre une longueur L_{S} d'un côté de la section polygonale S et une distance d entre deux centres C1, C2 de deux ouvertures 30 adjacentes, illustrée sur la Figure 3, est par exemple compris entre 0,1 et 0,5. De telles valeurs du rapport L_{S}/d assurent un taux d'occupation des ouvertures traversantes 30 sur la surface de la plaque 28 satisfaisant.

Comme illustré à la Figure 3, la distance d entre les centres C1, C2 de deux ouvertures 30 adjacentes est la même sur l'ensemble de la plaque 28. La distribution des ouvertures traversantes 30 sur la plaque 28 est alors régulière, permettant d'obtenir un refroidissement régulier grâce à la plaque 28. La rigidité de la plaque 28 peut ainsi également être la même sur la zone de la plaque 28 où des ouvertures traversantes 30 sont réalisées. En outre, ceci peut faciliter la fabrication de la plaque 28, notamment par poinçonnage.

Alternativement, la plaque 28 peut comprendre des zones dépourvue d'ouvertures traversantes 30. Ainsi, ces zones présentent une rigidité supérieure au reste de la plaque 28. Avantageusement, une fabrication par poinçonnage permet d'éviter les zones nécessitant une rigidité plus importante.

Comme illustré sur la Figure 3, les ouvertures traversantes 30 sont disposées selon un maillage. Par maillage, on entend ici une division régulière ou non du plan de la plaque 28, par un motif ou plusieurs, qui est/sont répétés. En l'espèce, le maillage est régulier qui se compose d'un motif M se répétant selon deux directions *̅u̅*̅, *̅v̅*̅ linéairement indépendantes. Une répartition des ouvertures traversantes 30 selon un tel maillage régulier permet d'obtenir un refroidissement régulier sur toute la surface de la plaque 28. En outre, on obtient ainsi un compromis satisfaisant entre la rigidité et le poids de la plaque 28.

Par exemple, sur la Figure 3, un motif M est un parallélogramme formé par les centres C3, C4, C5, C6, de quatre ouvertures traversantes 30 voisines. Un tel motif M permet d'optimiser le taux d'occupation des ouvertures traversantes 30 sur la plaque 28, tout en conservant une rigidité satisfaisante de la plaque 28.

Le maillage M illustré à la Figure 3 peut toutefois être qualifié de maillage en nid d'abeille, en ce que les ouvertures traversantes 30, hexagonales, dessinent ici un nid d'abeille. Ainsi, dans ce maillage, chaque côté d'une ouverture traversante 30 s'étend parallèlement et en regard d'un côté d'une ouverture traversante 30 voisine. Ce type de maillage permet avantageusement de maximiser le nombre d'ouvertures traversantes 30 sur la plaque 28 tout en conservant une rigidité de la plaque 28.

Le motif M est distribué sur sensiblement l'ensemble de la surface principale de la plaque 28. En effet, le bord de la plaque 28 est ici dépourvu d'ouvertures traversantes 30.

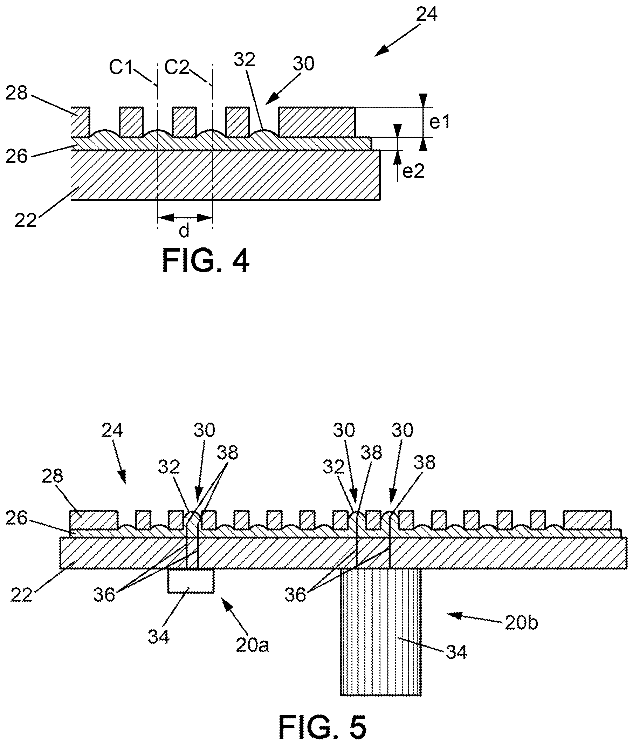

Comme visible sur la Figure 4, le dissipateur thermique 24 comprend de la pâte thermique 26, disposée entre la carte électronique 22 et la plaque 28. La pâte thermique 26 comble ainsi des microcavités présentes entre la plaque 28 et la carte électronique 22. Les microcavités présentes entre la plaque 28 et la carte électronique 22 seraient susceptibles de piéger l'air, qui a une forte résistance thermique. Ainsi, il est préférable de combler les microcavités au moyen de la pâte thermique 26, pour améliorer les transferts thermiques entre la carte électronique 22 et la plaque 28.

Par exemple, la pâte thermique 26 a une conductivité thermique comprise entre 1 W/mK et 50 W/mK. La conductivité thermique de la pâte thermique 26 est de préférence supérieure à celle de l'air.

La pâte thermique 26 forme par exemple une couche entre la carte électronique 22 et la plaque 28. L'épaisseur e2 de la couche, mesurée entre la plaque 28 et la carte électronique 22, est par exemple comprise entre 25 µm et 450 µm. L'épaisseur e2 est ainsi suffisante pour combler les microcavités entre la carte électronique 22 et la plaque 28. Néanmoins, la pâte thermique peut posséder une conductivité thermique plus faible que la plaque 28. Ainsi, il est préférable de limiter l'épaisseur e2 de la pâte thermique 26 pour un meilleur transfert thermique depuis la carte électronique 22, vers le flux d'air du ventilateur 24.

La pâte thermique 26 peut être collante. Dans ce cas, la pâte thermique 26 peut permettre de fixer la plaque 28 à la carte électronique 22. Une telle pâte thermique 26 collante est par exemple du Silicone SEMICOSIL ^{®} 9712.

Lorsque la pâte thermique 26 est collante, la plaque 28 et/ou la carte électronique 22 peut/peuvent être dépourvue/s de trous pour des vis de fixation ou des bouterolles. En effet, dans ce cas, la fixation de la plaque 28 avec la carte électronique 22 peut être réalisée au moyen de la seule pâte thermique 26, de préférence sans mettre en œuvre aucune vis de fixation. Un trou de fixation par une vis ou bouterolle se distingue d'une ouverture traversante 30, notamment par sa forme circulaire, éventuellement taraudée, et/ou par l'aire de sa section, inférieure à l'aire A de la section S d'un trou traversant 30.

La pâte thermique 26 peut par ailleurs être étanche. Par étanche, on entend ici étanche à l'eau. Dans ce cas, la pâte thermique 26 permet de protéger la carte électronique 22 et les composants électroniques 20 contre l'humidité présente dans le flux d'air généré par le ventilateur 14. Une telle pâte thermique 26 étanche est par exemple du Silicone SEMICOSIL^{®} 9712.

La pâte thermique 26 peut également être à la fois collante et étanche. Une telle pâte thermique 26, à la fois collante et étanche, est par exemple du Silicone SEMICOSIL^{®} 9712.

Si la pâte thermique 26 n'assure pas l'étanchéité en périphérie de la plaque 28, un joint peut être disposé à la périphérie de la plaque 28 afin d'assurer cette étanchéité. Le joint évite que l'air s'écoulant le long de la plaque 28 entre en contact avec les composants électroniques 20 situés sur la face de la carte électronique 22 opposée à la face fixée à la plaque 28. La présence du joint permet par exemple d'utiliser une pâte thermique 26 non étanche.

La couche de pâte thermique 26 peut former un relief 32 saillant, à l'intérieur des ouvertures traversantes 30, comme illustré sur la Figure 4. Le relief 32 peut être formé sous l'effet du poids de la plaque 28 sur la pâte thermique 26.

Sur la Figure 5, deux composants électroniques 20a, 20b fixés sur la carte électronique 22 sont illustrés. Chaque composant électronique 20a, 20b comprend, tel qu'illustré, un corps 34 et, ici, deux pattes fixation 36. Chaque patte de fixation 36 s'étend ici, depuis le corps 34 du composant électronique 20a, 20b associé, vers la plaque 28, en traversant la carte électronique 22. Ici, chaque patte de fixation 36 s'étend depuis le corps 34 du composant électronique 20a, 20b associé, jusqu'à une extrémité libre 38 de la patte de fixation 36 considérée. Chaque extrémité libre 38 est ici reçue dans une ouverture traversante 30. Ceci permet d'éviter un contact entre la plaque 28 et un composant électronique 20a, 20b. En outre, les extrémités libres 36 des différentes pattes de fixation 36 ne font pas saillie de la plaque 28.

Dans l'exemple de la figure 5, la portion des pattes de fixation 36 entre la carte électronique 28 et l'extrémité libre 38 des pattes de fixation 36 ne fait pas saillie de la couche de pâte thermique 26. Ainsi, l'extrémité libre 38 des pattes de fixation 36, notamment, est recouverte de pâte thermique 26. Ainsi, l'extrémité libre 38 des pattes de fixation 36 n'est pas en contact direct avec le milieu environnant. Ceci permet par exemple de protéger les composants électroniques 20a, 20b de l'humidité du flux d'air généré par le ventilateur 14, notamment lorsque la pâte thermique 26 est étanche.

Comme illustré sur la Figure 5, le premier composant électronique 20a présente deux pattes de fixation 36 telle que la distance entre les deux pattes de fixation 36 est inférieure au diamètre d'un trou traversant. Par « diamètre », on entend ici, au sens large, la plus grande distance mesurée entre deux points de la section S du trou traversant 30. Dans ce cas, avantageusement, les deux pattes de fixation 36 du composant électronique 20a peuvent être reçues dans un même trou traversant 30.

Alternativement, la distance entre les pattes de fixation 36 d'un composant électronique 20b, est de préférence choisie de telle sorte que les pattes de fixation 36 soient reçues dans des ouvertures traversantes 30 distinctes. On limite ainsi les risques de contact entre les pattes de fixation 36. Notamment, comme illustrée à la Figure 5, la distance entre les pattes de fixation 36 d'un composant électronique 20b est choisie de manière que les pattes de fixation 36 soient reçues dans des ouvertures traversantes 30 adjacentes. Pour ce faire, on choisit par exemple des composants électronique 20 dont la distance entre les pattes de fixation 36 est sensiblement égale à la distance d entre le centre C1, C2 de deux ouvertures traversantes 30 adjacentes.

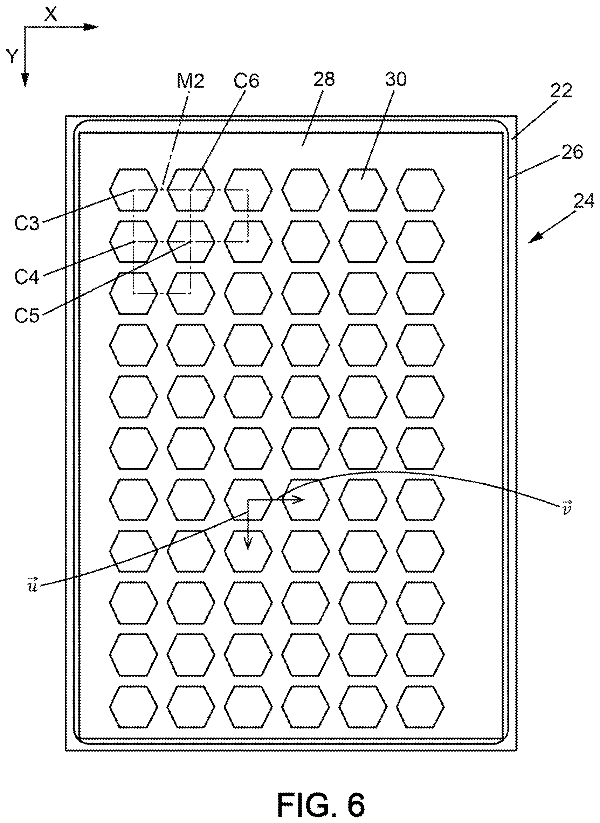

La Figure 6 illustre un deuxième exemple de plaque 28, sur laquelle les ouvertures traversantes 30 définissent un deuxième exemple de maillage. Le motif M2 distribué est formé par les centres C3, C4, C5, C6 de quatre ouvertures traversantes 30 voisines. Le motif M2 ainsi défini est un rectangle, qui se répète sur sensiblement toute la surface de la plaque 28, par translation selon deux directions *̅u̅*̅, *̅v̅*̅ perpendiculaires. On définit ainsi un maillage de quadrilatères, par répétition d'un motif en forme de quadrilatère.

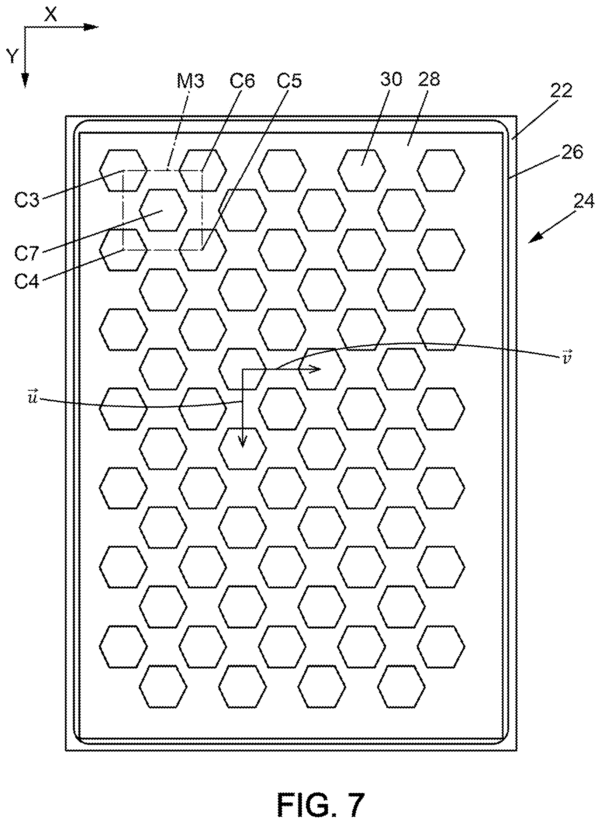

La Figure 7 illustre un troisième exemple de plaque 28, sur laquelle les ouvertures traversantes 30 définissent un troisième exemple de maillage. Les ouvertures traversantes 30 définissent ici un motif M3 de centres d'ouvertures traversantes 30 en quinconce. Par en quinconce, on entend ici que le motif M3 est défini par un groupe de cinq ouvertures traversantes 30 voisines, telles que les centres C3, C4, C5, C6 de quatre d'entre elles définissent un rectangle, en particulier un carré, et que le centre C7 de la cinquième ouverture traversante 30 se trouve sensiblement au centre du rectangle C3C4C5C6. Le motif M3 ainsi défini est rectangulaire, qui se répète sur sensiblement toute la surface de la plaque 28, par translation selon deux directions *̅u̅*̅, *̅v̅*̅ perpendiculaires. Le maillage ainsi réalisé peut être décrit comme un maillage de quadrilatères en quinconces. Ce type de maillage permet un compromis entre le taux d'occupation des ouvertures traversantes 30 sur la plaque 28 et la rigidité de la plaque 28.

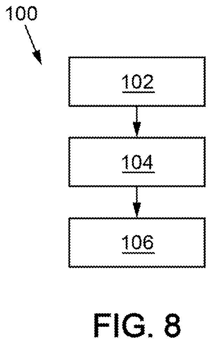

On va maintenant décrire, en regard de la Figure 8, un exemple de procédé 100 de fabrication d'un ensemble 11 d'une carte électronique 22 et d'un dissipateur thermique 24 tel que décrit ci-avant.

Tel qu'illustré, le procédé de fabrication 100 comprend une première étape 102 de fourniture de la plaque 28.

L'étape 102 de fourniture de la plaque peut comprendre une première sous-étape d'extrusion d'un profilé. Le profilé peut alors présenter autant de conduits longitudinaux que la plaque 28 comporte d'ouvertures traversantes 30. Le profilé peut notamment présenter une section transversale sensiblement identique à la section de la plaque 28. L'étape 102 de fourniture de la plaque 28 peut alors comporter une deuxième sous-étape de découpe du profilé obtenu à la première sous-étape, pour obtenir une plaque 28 d'épaisseur e1 souhaitée. Avantageusement, l'étape 102 de fourniture de la plaque 28 est alors dépourvue de toute autre sous-étape consécutive.

Alternativement, l'étape 102 de fourniture de la plaque 28 peut comprendre une première sous-étape de fourniture d'une plaque de section pleine, suivie d'une deuxième sous-étape de réalisation des ouvertures traversantes 30. Dans ce cas, les ouvertures traversantes 30 peuvent notamment être réalisées par poinçonnage.

Le procédé de fabrication 100 comprend alors une deuxième étape 104 d'application de la pâte thermique 26 sur la carte électronique 22 et/ou sur la plaque 28.

Le procédé de fabrication 100 se poursuit par une troisième étape 106 de fixation de la plaque 28 sur la carte électronique 22. L'étape de fixation 106 peut comporter une sous-étape de polymérisation à l'air de la pâte thermique 26. Alternativement, l'étape de fixation 106 peut comporter une sous-étape de polymérisation par chauffage de la pâte thermique 26. De manière avantageuse, l'étape de fixation 106 ne comprend pas de sous-étape de fixation par vissage de la plaque 28 sur la carte électronique 22 ni de bouterollage de la plaque 28 sur la carte électronique 22.

L'invention ne se limite pas aux seuls exemples décrits ci-avant mais est susceptible de nombreuses variantes accessibles à l'homme de l'art.

Dans les exemples décrits, les ouvertures traversantes 30 sont de section S polygonale. Les ouvertures traversantes 30 peuvent cependant être de section circulaire. Des ouvertures de section circulaires peuvent en effet être plus facilement réalisées, notamment par perçage ou poinçonnage.

Les ouvertures traversantes 30 peuvent ne pas toutes présenter la même section S sur l'ensemble de la plaque 28. Par exemple, des ouvertures traversantes 30 peuvent présenter une première section polygonale, et d'autres ouvertures traversantes 30 peuvent présenter une deuxième section polygonale ou une section circulaire.

Les ouvertures traversantes 30 peuvent être distribuées selon d'autres types de maillage que ceux décrits précédemment.

Notamment, un maillage est possible qui est constitué d'un motif reproduit selon un schéma irrégulier sur la plaque 28 ou sensiblement toute la plaque 28 (« maillage irrégulier »). Alternativement, un maillage est possible, qui consiste en la reproduction régulière ou irrégulière, de deux motifs ou plus.

Des ouvertures traversantes 30 peuvent ne pas être présentes sur toute la surface de la plaque 28, notamment pour rigidifier localement la plaque. En particulier, lorsque la plaque présente un trou de fixation par une vis ou bouterolle, il peut être préféré que la plaque 28 soit dépourvue d'ouvertures traversantes 30 au voisinage de ce trou de fixation par une vis ou bouterolle.

## Revendications

1. Ensemble (11) d'une carte électronique (22) et d'un dissipateur thermique (24), notamment pour un groupe moto-ventilateur (10) de véhicule automobile, comprenant :
- une carte électronique (22) ;
- un dissipateur thermique (24) comprenant une plaque (28) fixée à la carte électronique (22) dont la surface présente des ouvertures traversantes (30), et une pâte thermique (26) disposée entre la carte électronique (22) et la plaque (28), ledit ensemble (11) comprenant au moins un composant électronique (20a ; 20b) avec un corps de composant électronique (34) et au moins une patte de fixation (36) traversant la carte électronique (22) depuis le corps de composant électronique (34) vers la plaque (28), la patte de fixation (36) s'étendant au moins jusqu'à une ouverture traversante (30) de la plaque (28), une portion de la patte de fixation (36) entre la carte électronique (22) et une extrémité libre (38) étant recouverte par la pâte thermique (26).

2. Ensemble selon la revendication 1, dans lequel la pâte thermique (26) est étanche et/ou collante.

3. Ensemble selon la revendication 1 ou 2, dans lequel chaque ouverture traversante (30) de la plaque (28) a une section (S) polygonale, notamment hexagonale ou rectangulaire, ou circulaire.

4. Ensemble selon l'une des revendications précédentes, dans lequel les ouvertures traversantes (30) de la plaque (28) sont de section polygonale, un rapport entre l'épaisseur (e1) de la plaque (28) et la longueur (Ls) d'un côté de la section (S) polygonale étant compris entre 0,005 et 0,5.

5. Ensemble selon l'une quelconque des revendications précédentes, dans lequel les ouvertures traversantes (30) sont disposées selon un maillage de quadrilatères, par exemple rectangulaires et/ou en quinconce, ou selon un maillage en nid d'abeille.

6. Ensemble selon selon l'une quelconque des revendications précédentes, dans lequel le composant électronique (20a ; 20b) a au moins deux pattes de fixation (36), chaque patte de fixation (36) étant reçue dans une ouverture traversante (30).

7. Ensemble selon l'une quelconque des revendications précédentes, dans lequel la plaque (28) et/ou la carte électronique (22) est/sont dépourvue/s de trous de fixation par vis.

8. Ensemble selon l'une des revendications 1 à 6, dans lequel la plaque (28) comprend au moins un trou de fixation par une vis ou bouterolle, la plaque (28) étant de préférence dépourvue d'ouverture traversante (30) au voisinage du au moins un trou de fixation.

9. Groupe moto-ventilateur (10) pour un véhicule automobile, comprenant un moteur (12), une roue (15) de mise en mouvement d'un flux d'air configurée pour être entrainée par le moteur (12), un dispositif (18) de commande du moteur (12), le dispositif de commande (18) comportant un ensemble (11) d'une carte électronique (22) et d'un dissipateur thermique (24), selon l'une quelconque des revendications précédentes.

10. Procédé de fabrication d'un ensemble (11) d'une carte électronique (22) et d'un dissipateur thermique (24) selon l'une quelconque des revendications 1 à 8, comprenant les étapes de :
i) fourniture de la plaque (28), l'étape de fourniture de la plaque comportant de préférence une sous-étape d'extrusion d'un profilé dont la section correspond à la section de la plaque (28), puis une sous-étape de découpe d'une plaque (28) dans le profilé ;
ii) application de la pâte thermique (26) sur la carte électronique (22) et/ou sur la plaque (28) ; et
iii) fixation de la plaque (28) sur la carte électronique (22).

## Patentansprüche

1. Baugruppe (11) aus einer Leiterplatte (22) und einem Kühlkörper (24), insbesondere für einen Motorlüfter (10) eines Kraftfahrzeugs, umfassend:
- eine Leiterplatte (22);
- einen Kühlkörper (24) mit einer an der Leiterplatte (22) befestigten Platte (28), deren Oberfläche Durchgangsöffnungen (30) aufweist, und einer zwischen der Leiterplatte (22) und der Platte (28) angeordneten Wärmeleitpaste (26), wobei die Anordnung (11) mindestens ein elektronisches Bauteil (20a; 20b) mit einem elektronischen Bauteilkörper (34) und mindestens einer Befestigungslasche (36) umfasst, die Leiterplatte (22) vom elektronischen Bauteilkörper (34) zur Platte (28) durchquert, wobei sich die Befestigungslasche (36) mindestens bis zu einer Durchgangsöffnung (30) der Platte (28) erstreckt und ein Abschnitt der Befestigungslasche (36) zwischen der Leiterplatte (22) und einem freien Ende (38) von der Wärmeleitpaste (26) bedeckt ist.

2. Anordnung nach Anspruch 1, wobei die Wärmeleitpaste (26) dicht und/oder klebrig ist.

3. Anordnung gemäß Anspruch 1 oder 2, wobei jede Durchgangsöffnung (30) der Platte (28) einen polygonalen, insbesondere hexagonalen oder rechteckigen oder kreisförmigen Querschnitt (S) aufweist.

4. Anordnung gemäß einem der vorstehenden Ansprüche, wobei die Durchgangsöffnungen (30) der Platte (28) einen polygonalen Querschnitt aufweisen, wobei das Verhältnis zwischen der Dicke (e1) der Platte (28) und der Länge (L_{S} ) einer Seite des polygonalen Querschnitts (S) zwischen 0,005 und 0,5 liegt.

5. Anordnung gemäß einem der vorstehenden Ansprüche, wobei die Durchgangsöffnungen (30) in einem Gitter aus beispielsweise rechteckigen und/oder versetzt angeordneten Vierecken oder in einem Wabengitter angeordnet sind.

6. Anordnung gemäß einem der vorstehenden Ansprüche, wobei die elektronische Komponente (20a; 20b) mindestens zwei Befestigungslaschen (36) aufweist, wobei jede Befestigungslasche in einer Durchgangsöffnung (30) aufgenommen ist.

7. Anordnung gemäß einem der vorstehenden Ansprüche, wobei die Platte (28) und/oder die Leiterplatte (22) keine Schraubenbefestigungslöcher aufweisen.

8. Anordnung gemäß einem der Ansprüche 1 bis 6, wobei die Platte (28) mindestens ein Befestigungsloch für eine Schraube oder einen Bolzen aufweist, wobei die Platte (28) vorzugsweise keine Durchgangsöffnung (30) in der Nähe des mindestens einen Befestigungslochs aufweist.

9. Lüftermotorbaugruppe (10) für ein Kraftfahrzeug, umfassend einen Motor (12), ein Rad (15) zum Bewegen eines Luftstroms, das so konfiguriert ist, dass es vom Motor (12) angetrieben wird, eine Vorrichtung (18) zum Steuern des Motors (12), wobei die Steuervorrichtung (18) eine Baugruppe (11) aus einer Leiterplatte (22) und einem Kühlkörper (24) umfasst, gemäß einem der vorstehenden Ansprüche.

10. Verfahren zur Herstellung einer Baugruppe (11) aus einer Leiterplatte (22) und einem Kühlkörper (24) gemäß einem der Ansprüche 1 bis 8 , mit den folgenden Schritten:
i) Bereitstellen der Platte (28), wobei der Schritt des Bereitstellens der Platte vorzugsweise einen Unterschritt des Extrudierens eines Profils, dessen Querschnitt dem Querschnitt der Platte (28) entspricht, und anschließend einen Unterschritt des Schneidens einer Platte (28) aus dem Profil umfasst;
ii) Aufbringen der Wärmeleitpaste (26) auf die Leiterplatte (22) und/oder auf die Platte (28); und
iii) Befestigen der Platte (28) auf der Leiterplatte (22).

## Claims

1. Assembly (11) comprising an electronic board (22) and a heat sink (24), in particular for a motor-fan unit (10) in a motor vehicle, comprising:
- an electronic board (22);
- a heat sink (24) comprising a plate (28) fixed to the electronic board (22), the surface of which has through-openings (30), and a thermal paste (26) disposed between the electronic board (22) and the plate (28), said assembly (11) comprising at least one electronic component (20a; 20b) with an electronic component body (34) and at least one fastening tab (36) passing through the electronic board (22) from the electronic component body (34) to the plate (28), the fastening tab (36) extending at least to a through opening (30) in the plate (28), a portion of the fastening tab (36) between the electronic board (22) and a free end (38) being covered by the thermal paste (26).

2. Assembly according to claim 1, wherein the thermal paste (26) is waterproof and/or adhesive.

3. Assembly according to claim 1 or 2, wherein each through opening (30) in the plate (28) has a polygonal, in particular hexagonal or rectangular, or circular cross-section (S).

4. Assembly according to one of the preceding claims, in which the through openings (30) in the plate (28) have a polygonal cross-section, with a ratio between the thickness (e1) of the plate (28) and the length (Ls) of one side of the polygonal cross-section (S) being between 0.005 and 0.5.

5. Assembly according to any of the preceding claims, in which the through openings (30) are arranged in a grid of quadrilaterals, for example rectangular and/or staggered, or in a honeycomb grid.

6. Assembly acccording to any of the preceding claims, wherein the electronic component (20a; 20b) has at least two mounting tabs (36), each fastening tab (36) being received in a through opening (30).

7. Assembly according to any of the preceding claims, wherein the plate (28) and/or the electronic board (22) is/are devoid of screw mounting holes.

8. Assembly according to any of claims 1 to 6, wherein the plate (28) comprises at least one screw or stud fastening hole, the plate (28) preferably having no through opening (30) in the vicinity of the at least one fastening hole.

9. Motor fan unit (10) for a motor vehicle, comprising a motor (12), an impeller (15) for moving an air flow configured to be driven by the motor (12), a device (18) for controlling the motor (12), the control device (18) comprising an assembly (11) of an electronic board (22) and a heat sink (24), according to any of the preceding claims.

10. Method for manufacturing an assembly (11) of an electronic board (22) and a heat sink (24) according to any of claims 1 to 8 , comprising the steps of:
i) providing the plate (28), the step of providing the plate preferably comprising a sub-step of extruding a profile whose cross-section corresponds to the cross-section of the plate (28), then a sub-step of cutting a plate (28) from the profile;
ii) applying the thermal paste (26) to the electronic board (22) and/or to the plate (28); and
iii) fixing the plate (28) to the electronic board (22).
